Europäisches Patentamt

European Patent Office

Office européen des brevets

(19)

(11) **EP 0 852 846 B1**

(12) **FASCICULE DE BREVET EUROPEEN**

(45) Date de publication et mention
de la délivrance du brevet:
**14.07.1999 Bulletin 1999/28**

(21) Numéro de dépôt: **96932623.0**

(22) Date de dépôt: **20.09.1996**

(51) Int Cl.⁶: **H03H 9/64**

(86) Numéro de dépôt international:
**PCT/FR96/01469**

(87) Numéro de publication internationale:
**WO 97/12441 (03.04.1997 Gazette 1997/15)**

(54) **FILTRE A ONDES ACOUSTIQUES DE SURFACE UTILISANT LE COUPLAGE DE TROIS VOIES ACOUSTIQUES**

OBERFLÄCHENFILTER UNTER VERWENDUNG DER KOPPLUNG ZWISCHEN DREI AKUSTISCHEN SPUREN

SURFACE ACOUSTIC WAVE FILTER USING THE COUPLING OF THREE ACOUSTIC CHANNELS

(84) Etats contractants désignés:
**CH DE FI FR GB IT LI SE**

(30) Priorité: **26.09.1995 FR 9511267**

(43) Date de publication de la demande:
**15.07.1998 Bulletin 1998/29**

(73) Titulaire: **THOMSON-CSF**
**75008 Paris (FR)**

(72) Inventeurs:
• **SOLAL, Marc**
  **F-92402 Courbevoie Cédex (FR)**

• **DESBOIS, Jean**
  **F-92402 Courbevoie Cédex (FR)**

(74) Mandataire: **Lincot, Georges et al**
**Thomson-CSF Propriété Intellectuelle,**
**13, Avenue du Président Salvador Allende**
**94117 Arcueil Cédex (FR)**

(56) Documents cités:
**EP-A- 0 648 015          FR-A- 2 682 833**

• **PATENT ABSTRACTS OF JAPAN vol. 012, no. 418 (E-678), 7 Novembre 1988 & JP,A,63 155810 (HITACHI LTD), 29 Juin 1988,**

## Description

La présente invention concerne un filtre à ondes acoustiques de surface à résonateurs à couplage transversal utilisant le couplage de trois voies acoustiques. Les filtres à ondes acoustiques de surface sont utilisés dans de nombreuses applications, en particulier dans les téléphones portatifs.

De tels filtres utilisent la propagation des ondes acoustiques sur la surface d'un substrat piézo-électrique, et les caractéristiques de filtrage proviennent des modifications apportées à la propagation de ces ondes en fonction de leur fréquence par des électrodes convenablement disposées à la surface du substrat. Il existe plusieurs structures pour ces électrodes et on choisit entre elles en fonction des résultats à obtenir. Parmi ces structures, on connaît plus particulièrement celles qui utilisent des résonateurs couplés transversalement par proximité.

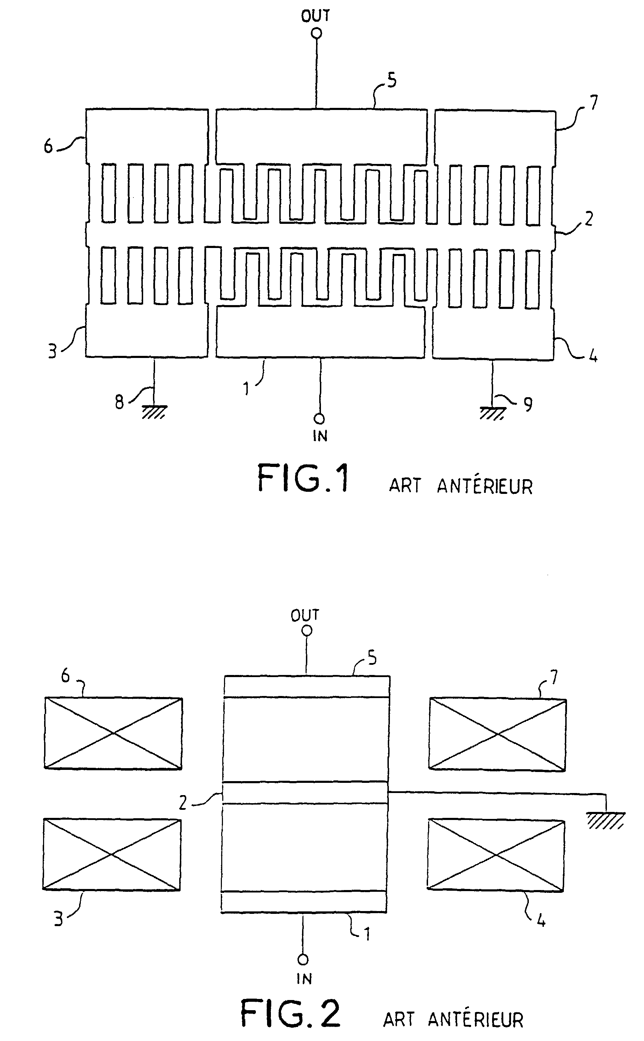

Sur la figure 1, la structure des électrodes d'un filtre à deux pôles utilisant des résonateurs à couplage transversal est représentée. Pour des raisons de clarté la structure décrite ici est très simple et comporte en particulier un petit nombre de doigts pour les électrodes, ce qui donnerait pour un filtre réalisé identiquement à cette structure des performances de filtrage relativement médiocres. Toutefois cette structure est bien caractéristique des filtres de ce type et les réalisations pratiques diffèrent essentiellement par l'augmentation du nombre de doigts.

Ce filtre à deux pôles est constitué par deux résonateurs formés chacun d'un transducteur situé entre deux réseaux réflecteurs et couplé par proximité. Les transducteurs et les réseaux réflecteurs ont une période de métallisation d'environ une demi-longueur d'onde. Le premier résonateur est relié à l'entrée du filtre et le deuxième résonateur à la sortie.

Le résonateur d'entrée comprend une électrode 1 en forme de peigne dont les doigts sont interdigités avec les doigts d'une électrode de masse 2. Les ondes acoustiques ainsi générées par ce transducteur sont émises vers la droite et vers la gauche vers des réflecteurs 3 et 4 et formés par des doigts parallèles aux doigts des transducteurs et obtenus par découpe de l'électrode de masse 2. Le résonateur relié à la sortie est symétrique de ce résonateur relié à l'entrée par rapport à un axe parallèle à la direction de propagation des ondes acoustiques générées par le résonateur d'entrée. Il comporte un transducteur 5 et deux réflecteurs 6 et 7. La masse étant commune, l'électrode de masse 2 correspondante est ici d'un seul tenant et est reliée ici à deux sorties de masse 8 et 9 et uniquement pour des facilités de connexions au circuit extérieur au filtre. On pourrait soit n'utiliser qu'une seule sortie de masse soit séparer les masses.

Le couplage des deux résonateurs se fait par le rapprochement entre ceux-ci selon l'implantation de la figure 1. Dans ces conditions, on peut considérer au premier ordre que la structure est équivalente à celle obtenue en rapprochant deux guides d'ondes. Chacun des modes de propagations des guides considérés seuls se transforme en deux modes, un mode symétrique et un mode antisymétrique.

Lorsque la distance entre les deux résonateurs est grande, les vitesses des ondes acoustiques dans ces deux modes sont très proches et sensiblement égales à la vitesse du mode d'un guide isolé. Le couplage est alors très faible, ce qui est d'autant plus évident que les résonateurs sont éloignés. Quand la distance entre les deux résonateurs diminue, les vitesses des ondes dans les deux modes s'écartent et le couplage augmente.

On peut montrer que le schéma équivalent d'une telle structure correspond à celui obtenu pour deux résonateurs couplés avec un couplage égal à un écart normalisé entre les fréquences $f_s$ et $f_a$, des deux modes respectivement symétriques et antisymétriques donnés par la formule suivante :

$$k = 2 \frac{f_a - f_s}{f_a + f_s}$$

Ce couplage définit ainsi la bande passante relative que l'on peut obtenir avec ce type de filtre.

En général, avec un filtre à deux pôles, on obtient une réjection trop faible, ainsi qu'une raideur des flancs de la bande passante trop faible. On est alors amené à réaliser des filtres à quatre ou six pôles, voire plus tout simplement en cascadant plusieurs structures à deux pôles.

On a représenté sur la figure 2 la structure du filtre précédemment décrit et illustré par la figure 1. Le dessin est fait de manière simplifiée en représentant les éléments par des rectangles dans lesquels on n'a pas fait figurer les doigts des électrodes de manière à rendre la représentation plus lisible. Le dessin des électrodes à l'intérieur de ces rectangles sera fait conformément aux règles bien connues de l'homme de l'art.

Les éléments homologues à ceux de la figure 1 sont désignés par les mêmes repères. Cette présentation sera conservée pour les autres figures annexées à la présente description.

A partir de cette structure de base, illustrée aux figures 1 et 2, d'autres structures connues de filtres sont réalisées. Parmi celles-ci, celle illustrée à la figure 3. Cette structure est relative à un filtre à deux pôles à entrées différentielles IN +, IN - et sortie non différentielle OUT mettant en oeuvre quatre voies acoustiques 10, 11, 12 et 13.

La symétrie d'un tel filtre est obtenue en mettant en parallèle deux filtres 14 et 15 de structure intrinsèque identique mais dont les entrées différentielles ont été inversées. Dans la structure de chacun des deux filtres 14 et 15, le bus central 2 correspondant aux bus de masse dans le filtre des figures 1 et 2 n'est plus commun aux deux pôles mais séparé en deux bus distincts: un bus de masse 16, 17 et un bus 18, 19 relié à une des entrées différentielles. Pour obtenir une impédance d'entrée faible, les transducteurs sont branchés directement entre les entrées différentielles. L'inversion des entrées est compensée par une inversion des polarités des transducteurs. L'inconvénient d'une telle structure réside dans la largeur du substrat nécessaire pour réaliser le filtre.

La présente invention a pour but de pallier les inconvénients précités.

A cet effet, l'invention a pour objet un filtre à ondes acoustiques de surface à résonateurs à couplage transversal, comprenant trois voies acoustiques couplées par proximité, caractérisé en ce que :

- la première voie acoustique composée d'un premier transducteur, comportant une première et une deuxième plage de connexion, disposé entre un premier réflecteur et un deuxième réflecteur forme un premier résonateur,
- la deuxième voie acoustique composée d'un deuxième transducteur, comportant une troisième plage de connexion et une quatrième plage de connexion, disposé entre un troisième réflecteur et un quatrième réflecteur forme un deuxième résonateur, et
- la troisième voie acoustique composée d'un troisième transducteur, comportant une cinquième et une sixième plage de connexion, disposé entre un cinquième réflecteur et un sixième réflecteur forme un troisième résonateur,

    et en ce que chaque plage de connexion des transducteurs est reliée à un potentiel déterminé et en ce que le deuxième résonateur est connecté en mode différentiel.

Le filtre selon l'invention a donc pour principal avantage de réduire l'encombrement du filtre qui peut être une contrainte importante pour des matériels portatifs.

D'autres avantages et caractéristiques de la présente invention apparaîtront plus clairement à la lecture de la description qui suit faite en référence aux figures annexées qui représentent :

- la figure 1 déjà citée, une première structure connue d'un filtre à deux pôles à couplage transversal,
- la figure 2 déjà citée, une représentation simplifiée du filtre de la figure 1,

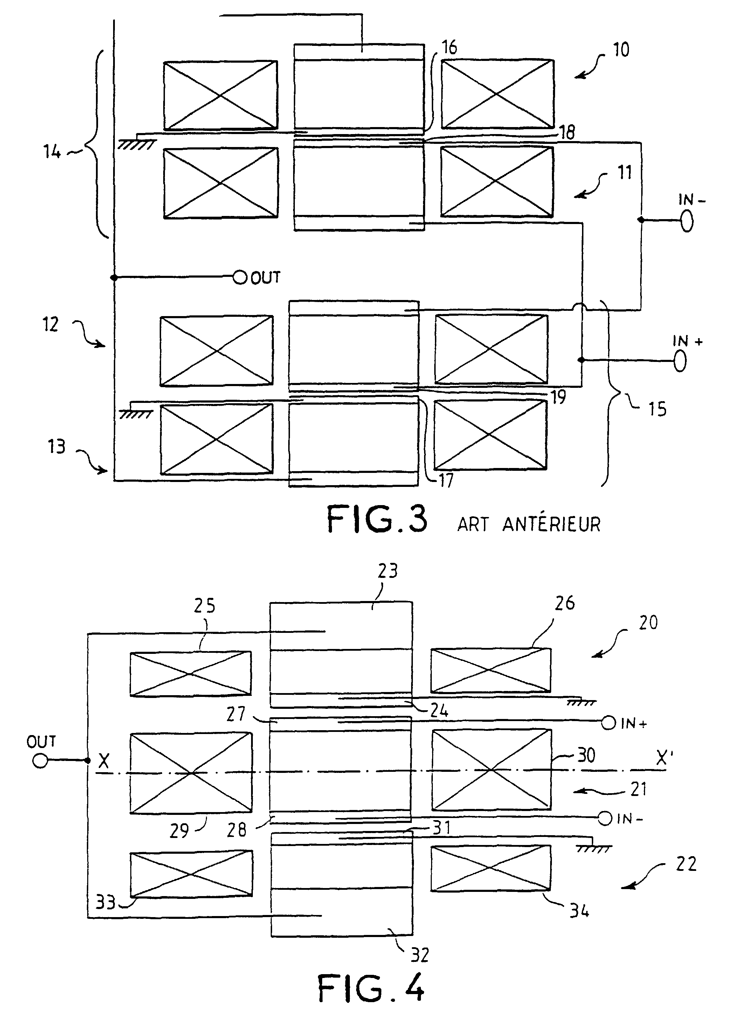

- la figure 3 déjà citée, la structure d'un filtre à deux pôles comprenant quatre voies acoustiques,
- la figure 4, la structure d'un filtre à deux pôles à trois voies acoustiques selon l'invention à entrées différentielles et sortie non différentielle,

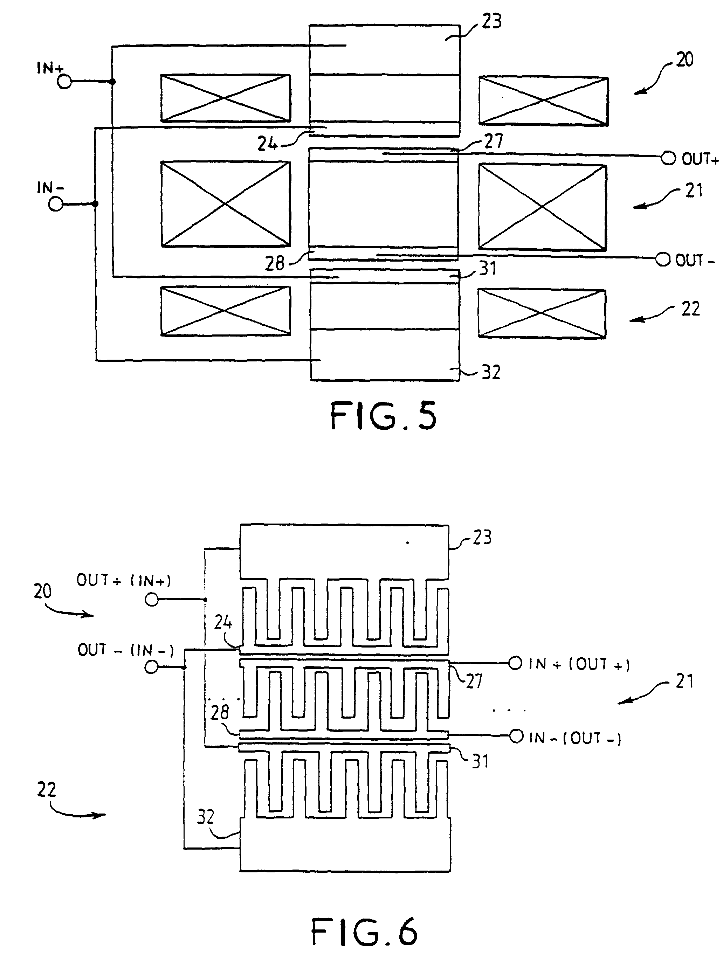

- la figure 5, une structure d'un filtre à trois voies acoustiques selon l'invention à entrées et sorties différentielles,

- la figure 6, une structure détaillée du filtre à trois voies acoustiques à entrées et sorties différentielles de la figure 5,

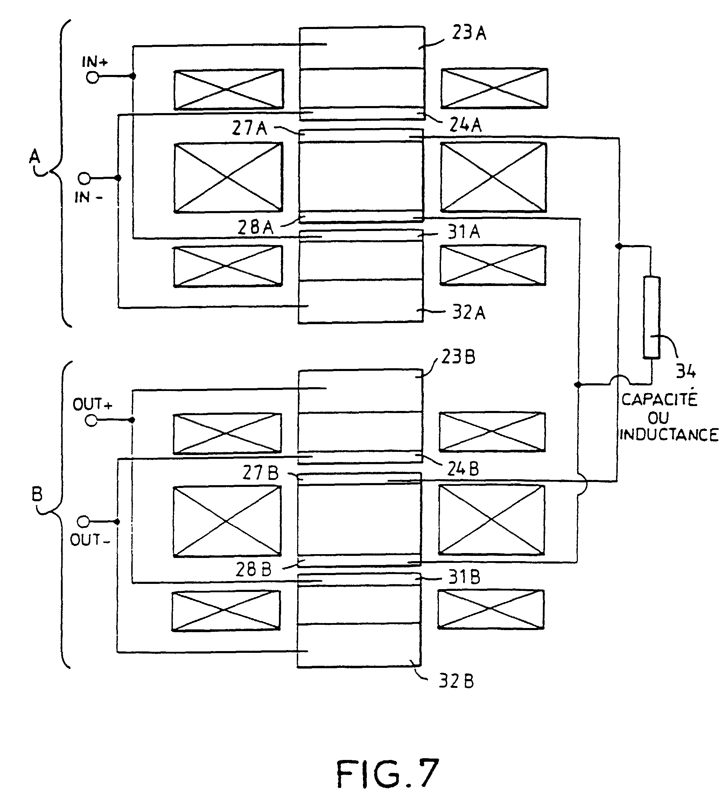

- la figure 7, une structure de filtre à quatre pôles selon l'invention à entrées et sorties différentielles et à couplage différentiel,

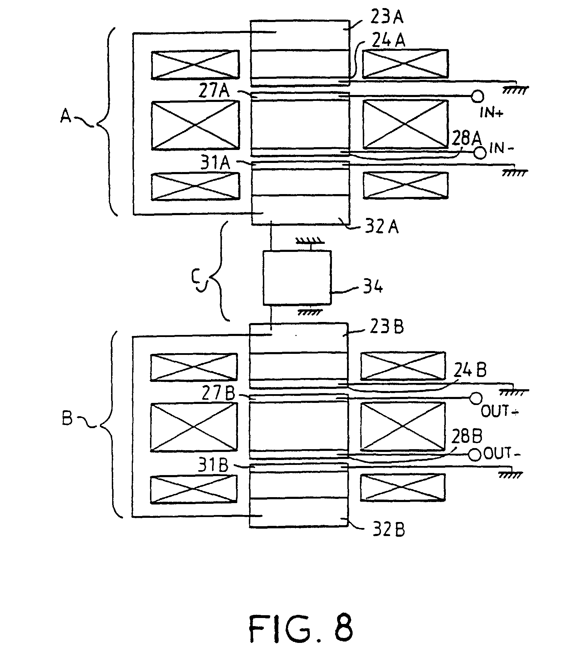

- la figure 8, une structure de filtre à quatre pôles selon l'invention à entrées et sorties différentielles et à couplage non différentiel,

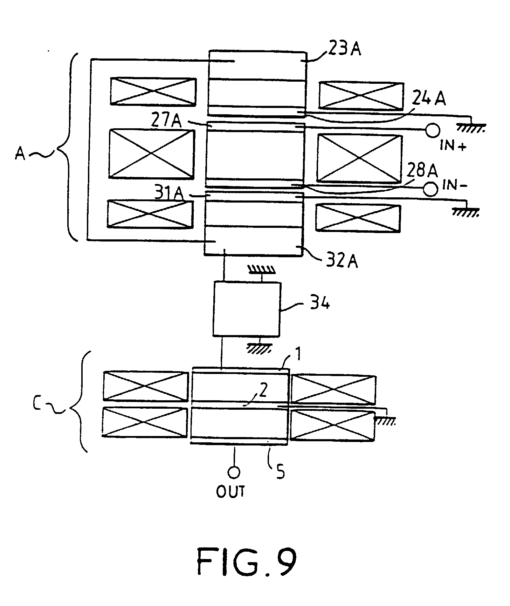

- la figure 9, un filtre à quatre pôles selon l'invention à entrées différentielles et sortie non différentielle et à couplage non différentiel,

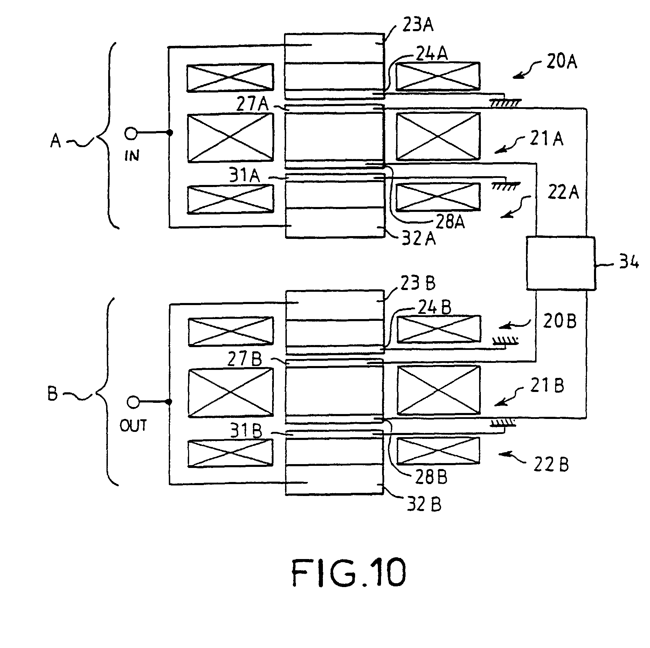

- la figure 10, une structure de filtre à quatre pôles selon l'invention à entrées et sorties non différentielles et à couplage différentiel, et

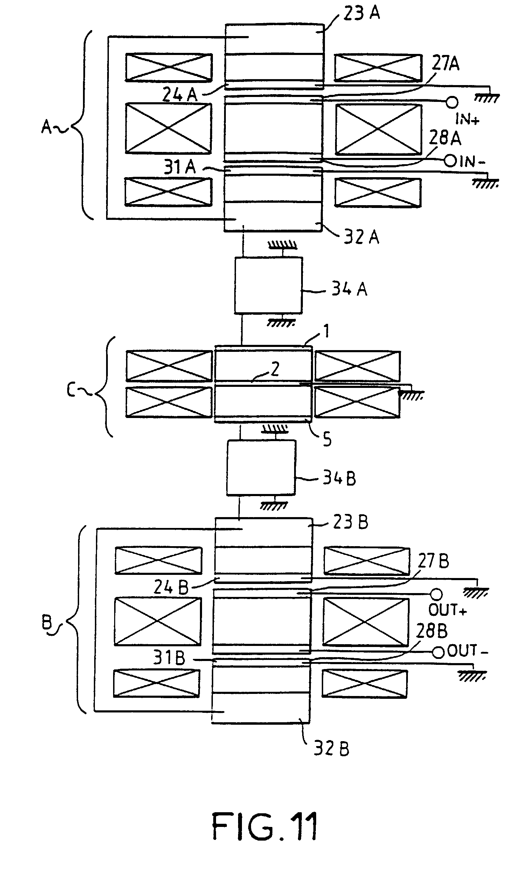

- la figure 11, une structure de filtre à six pôles à entrées/sorties différentielles et couplage non différentiel selon l'invention.

Les éléments homologues des figures 4 à 11 sont désignés par le même repère.

La figure 4 illustre une structure de filtre à trois voies acoustiques 20, 21 et 22 selon l'invention à entrées différentielles IN +, IN - et sortie non différentielle OUT. Les trois voies acoustiques 20, 21 et 22 sont formées chacune d'un résonateur, et sont couplés les unes aux autres par rapprochement.

Un résonateur est formé à partir d'un transducteur disposé entre deux réflecteurs.

Un transducteur est constitué de deux électrodes formant deux peignes entrelacés, comportant chacune une plage de connexion destinée à être reliée à un potentiel déterminé.

Pour simplifier la représentation des structures de filtre selon l'invention, les transducteurs apparaissent sur les figures annexées à la présente description, comme des rectangles dans lesquels se distinguent les plages de connexion relatives respectivement à chaque peigne d'électrode non représenté. Les repères associés aux plages de connexion serviront par la suite à définir chaque transducteur.

Le premier résonateur, formé d'un premier transducteur comportant une première plage de connexion 23 et une deuxième plage de connexion 24, est disposé entre un premier réflecteur 25 et un deuxième réflecteur 26 pour former la première voie acoustique 20.

Le deuxième résonateur, formé à partir d'un deuxième transducteur comportant une troisième plage de connexion 27 et une quatrième plage de connexion 28, est disposé entre un troisième réflecteur 29 et un quatrième réflecteur 30 pour former la deuxième voie acoustique 21.

Le troisième résonateur, formé à partir d'un troisième transducteur comportant une cinquième plage de connexion 31 et une sixième plage de connexion 32, est disposé entre un cinquième réflecteur 33 et un sixième réflecteur 34 pour former la troisième voie acoustique 22.

Les deux transducteurs extérieurs 23, 24 et 31, 32 respectifs à la première et à la troisième voie 20 et 22, sont branchés en parallèle à la sortie non différentielle OUT. La première plage de connexion 23 et la sixième plage de connexion 32 sont reliées toutes les deux à la sortie non différentielle OUT. La deuxième plage de connexion 24 et la cinquième plage de connexion 31 sont toutes les deux reliées à un potentiel de référence, par exemple la masse.

Le transducteur central 27, 28, respectif à la deuxième voie 21, est branché sur les entrées différentielles IN +, IN -. La troisième plage de connexion 27 est reliée à une des entrées différentielles IN + et la quatrième plage de connexion 28 est reliée à l'autre entrée différentielle IN -. Cette structure est symétrique par rapport à un axe horizontal XX' passant au milieu du transducteur central 27, 28. Les modes de propagation existant dans cette structure sont donc soit des modes symétriques soit des modes asymétriques. L'excitation électrique étant symétrique, seuls les modes symétriques sont couplés. Seuls les deux premiers modes symétriques sont utilisés. Par rapport à la structure du filtre de l'art antérieur illustrée à la figure 3, l'avantage réside dans une plus petite largeur utile de substrat support du filtre, avec une impédance d'entrée ayant le même ordre de grandeur.

Les largeurs des deux voies extérieures 20 et 22 formées respectivement par le premier et le troisième résonateur sont identiques de manière à conserver une structure symétrique. Pour obtenir le même couplage pour les deux modes symétriques utiles, les largeurs des voies extérieures 20 et 22 peuvent être choisies proches de la largeur de la voie centrale 21.

Il est également possible d'utiliser une structure à trois voies acoustiques pour réaliser un filtre deux pôles à entrées et sorties différentielles. Cette structure est illustrée sur la figure 5. Le transducteur central 27, 28 est branché entre les deux sorties différentielles OUT- et OUT+ alors que les deux transducteurs 23, 24 et 31, 32 des voies extérieures 20 et 22 sont branchés en parallèle entre les deux entrées différentielles IN - et IN +. Pour garder symétriques les deux entrées IN + et IN -, la première entrée différentielle IN + est reliée à la première plage de connexion 23 et à la cinquième plage de connexion 31 alors que la deuxième entrée différentielle IN- est reliée à la deuxième et la sixième plage de connexion 24 et 32. Les deux entrées différentielles IN +, IN - étant respectivement reliées à une plage de connexion étroite, 31 et 24, et à une plage de connexion large 23 et 32. Les impédances vues par les deux entrées différentielles IN +, IN - sont donc identiques. La troisième plage de connexion 27 et la quatrième plage de connexion 28 sont respectivement reliées à une des sorties différentielles OUT+, OUT-. Pour rétablir la symétrie de l'excitation électrique malgré l'inversion des connexions sur les transducteurs extérieurs 23, 24 et 31, 32, il suffit d'inverser les polarités des électrodes des deux transducteurs. Du fait de la propriété de réciprocité des ondes acoustiques de surface, les entrées et les sorties peuvent être inversées.

La figure 6 illustre une structure schématique relative à la structure de filtre de la figure 5 dans laquelle peut se distinguer l'inversion de polarité des électrodes solidaires des plages de connexion. Cette structure est relative à un filtre à deux pôles à entrées et sorties différentielles. Contrairement à une structure mixte, il est possible de choisir les entrées et les sorties. L'entrée se fait par exemple sur la voie centrale 21 ou sur les deux autres voies 20 et 22. L'utilisation des voies extérieures comme entrée du filtre peut être favorable dans le cas où l'on cherche à réduire les impédances de source et de charge.

Les structures qui viennent d'être décrites, correspondent à des filtres à deux pôles. En fait, on réalise en général plutôt des filtres multipôles utilisant un nombre N de pôles, supérieur à deux, à entrées et sorties différentielles ou non différentielles. On peut notamment réaliser une structure de filtre à quatre pôles comportant deux étages, chaque étage correspondant à des structures à trois voies acoustiques semblables à celles qui viennent d'être décrites.

Une première structure d'un filtre à quatre pôles à entrées et sorties différentielles et à couplage différentiel est illustrée à la figure 7. Cette structure est constituée par la cascade de deux filtres à deux pôles à entrées et sorties différentielles du type de celui illustré à la figure 5. Le couplage des premier et deuxième étages A et B est réalisé en différentiel par l'intermédiaire d'un circuit de couplage 34, constitué par exemple, d'une inductance ou d'une capacité branchée en parallèle. Les branchements des transducteurs centraux 27 A, 28A et 27B, 28B respectifs au premier étage A et au deuxième étage B, c'est-à-dire les branchements des premières 23A, 23B, deuxièmes 24A, 24B, cinquièmes 31A, 31B et sixièmes 32A, 32B plages de connexion des deux étages A et B sur les étages centraux des deux étages, sont identiques aux branchements de la structure de la figure 5. Le couplage des deux étages A et B se fait par l'intermédiaire des troisième et quatrième plages de connexion 27A, 27B et 28A, 28B respectives aux premier et deuxième étages A et B, le circuit de couplage 34 constitué par exemple d'une inductance, ou d'une capacité de couplage en parallèle s'intercalant entre ces plages de connexion.

La figure 8 illustre une structure de filtre à quatre pôles à entrées et sorties différentielles et à couplage non différentiel des deux étages A et B. Les branchements des premier et deuxième étages A et B de la structure représentée à la figure 8 sont similaires à ceux représentés à la figure 4. Les transducteurs centraux des deux étages sont reliés respectivement aux entrées différentielles IN+ et IN - et aux sorties différentielles OUT+ et OUT-, et les transducteurs extérieurs de chacun des deux étages sont branchés en parallèle. Les troisième et quatrième plages de connexion 27A, 28A et 278, 288 de chaque étage A et B sont reliées respectivement à une des entrées et sorties différentielles IN +, IN - /OUT +, OUT - et la deuxième et cinquième plages de connexion 24A, 31A et 24B, 31B de chaque étage A et B sont reliées à un même potentiel de référence, par exemple la masse. Les première et sixième plages de connexion 23A, 32A et 23B, 32B de chaque étage A et B sont reliées entre elles et permettent le couplage du premier étage A avec le deuxième étage B par l'intermédiaire du circuit de couplage 34 ; les plages 23A et 32A constituant ainsi la sortie du premier étage A et les plages 23B et 32B, l'entrée du deuxième étage B.

Les structures des figures 7 et 8 ont la même fonction : filtre à quatre pôles à entrées et sorties différentielles. La structure de la figure 8 permet un branchement plus simple et sera donc en général préféré. L'avantage du couplage différentiel est de permettre de réaliser indifféremment les entrées et les sorties du filtre à quatre pôles sur les transducteurs centraux ou sur les transducteurs extérieurs, ce qui peut permettre de réduire les impédances de sources et de charge.

En combinant une structure de filtre deux pôles à trois voies, A, selon l'invention avec un filtre deux voies C tel que celui représenté à la figure 1 de l'art antérieur, on obtient un filtre à quatre pôles à entrées différentielles et sortie non différentielle et à couplage non différentiel, comme illustrée à la figure 9. Le branchement du filtre à trois voies acoustiques selon l'invention est identique à celui du premier étage A de la structure de filtre décrite à la figure 8 et n'est donc pas redécrit. Le couplage entre le filtre trois voies A et le filtre deux voies C se fait par l'intermédiaire d'un circuit de couplage 34 du même type que celui décrit précédemment. Le circuit de couplage 34 est placé entre les plages de connexion 23A et 32A des transducteurs extérieurs du premier étage A et la première plage de connexion 1 du filtre deux voies C. La sortie non différentielle OUT s'effectuant sur la quatrième plage de connexion 5 du filtre deux voies C. Un même bus 2 commun aux deux pôles du filtre deux voies C, est relié à un potentiel de référence, par exemple la masse.

La figure 10 illustre une autre structure de filtre à quatre pôles selon l'invention basée sur deux étages A et B et où les entrées et sorties sont non différentielles en utilisant un couplage différentiel. Dans cette structure, le branchement des voies extérieures de chaque étage, c'est-à-dire le branchement des première et troisième voies 20A, 22A et 20B, 22B de chaque étage A et B, sont identiques aux branchements de la structure de filtre illustrée à la figure 4 et n'est donc pas redécrit. Le couplage des deux étages A et B est effectué par l'intermédiaire du circuit de couplage 34 disposé entre la voie centrale 21A et 21B de chaque étage A et B.

Cette structure permet de diminuer le couplage direct entre les entrées et sorties de chacun des étages et donc d'améliorer la réjection. En effet, par symétrie, les couplages capacitifs de l'entrée sur la sortie sont égaux et se compensent.

La figure 11 illustre une structure de filtre à six pôles selon l'invention à entrées et sorties différentielles. Celle-ci peut être obtenue en combinant deux filtres deux pôles à trois voies A et B selon l'invention avec un filtre deux pôles C classique à deux voies par l'intermédiaire d'un premier et un deuxième circuits de couplage 34A et 34B en non différentiel. Cette structure entièrement symétrique reprend la structure illustrée à la figure 9. La sortie du filtre central deux voies C est couplée au deuxième étage B par l'intermédiaire du deuxième circuit de couplage 34B.

Les quelques exemples qui viennent d'être décrits montrent l'utilisation que l'on peut faire de la structure d'un filtre à trois voies selon l'invention qui n'est qu'une brique de base pour des filtres multipôles à résonateurs. Cette brique de base peut être combinée avec tous les types de filtres à résonateurs non limités aux structures qui viennent d'être décrites.

## Revendications

1. Filtre à ondes acoustiques de surface à résonateurs à couplage transversal, comprenant trois voies acoustiques couplées par proximité, caractérisé en ce que:

   - la première voie acoustique (20) composée d'un premier transducteur, comportant une première et une deuxième plage de connexion (23 et 24), disposé entre un premier réflecteur (25) et un deuxième réflecteur (26) forme un premier résonateur,
   - la deuxième voie acoustique (21) composée d'un deuxième transducteur, comportant une troisième plage de connexion et une quatrième plage de connexion (27 et 28), disposé entre un troisième réflecteur (29) et un quatrième réflecteur (30) forme un deuxième résonateur, et
   - la troisième voie acoustique (22) composée d'un troisième transducteur, comportant une cinquième et une sixième plage de connexion (31 et 32), disposé entre un cinquième réflecteur (33) et un sixième réflecteur (34) forme un troisième résonateur,

   et en ce que chaque plage de connexion des transducteurs est reliée à un potentiel déterminé et en ce que le deuxième résonateur est connecté en mode différentiel.

2. Filtre selon la revendication 1, caractérisé en ce que la deuxième plage de connexion (24) et la cinquième plage de connexion (31) sont reliées à un même potentiel de référence, en ce que la troisième plage de connexion (27) est reliée à une première entrée différentielle (IN+) et la quatrième plage de connexion (28) est reliée à une deuxième entrée différentielle (IN-), et en ce que la première plage de connexion (23) et la sixième plage de connexion (32) sont reliés à la sortie (OUT).

3. Filtre selon la revendication 1, caractérisé en ce que la première plage de connexion (23) et la cinquième plage de connexion (31) sont reliées à une première entrée différentielle (IN+), tandis que la deuxième plage de connexion (24) et la sixième plage de connexion (32) sont reliées à une deuxième entrée différentielle (IN-), et en ce que la troisième plage de connexion (27) est reliée à une première sortie différentielle (OUT+) tandis que la quatrième plage de connexion (28) est reliée à une deuxième sortie différentielle (OUT-) pour réaliser un filtre à deux pôles à entrées et sorties différentielles ; les entrées et sorties différentielles pouvant être inversées du fait de la symétrie du filtre.

4. Filtre à N pôles, avec N supérieur à deux, caractérisé en ce qu'il comporte au moins un premier étage (A) et un deuxième étage (B), constitués chacun d'une structure de filtre selon la revendication 1, et en ce qu'ils sont couplés l'un à l'autre par l'intermédiaire d'un circuit de couplage (34; 34A; 34B).

5. Filtre selon la revendication 4, caractérisé en ce la première plage de connexion (23A) et la cinquième plage de connexion (31A) du premier étage (A) sont reliées à une première entrée différentielle (IN+), en ce que la deuxième plage de connexion (24A) et la sixième plage de connexion (32A) du premier étage (A) sont reliées à une deuxième entrée différentielle (IN-), en ce que la première plage de connexion (23B) et la cinquième plage de connexion (31B) du deuxième étage (B) sont reliées à une première sortie différentielle (OUT+), en ce que la deuxième plage de connexion (24B) et la sixième plage de connexion (32B) du deuxième étage (B) sont reliées à une deuxième sortie différentielle (OUT-) et, en ce que la troisième plage de connexion (27A) et la quatrième plage de connexion (28A) du premier étage (A) sont reliées respectivement à la troisième plage de connexion (27B) et à la quatrième plage de connexion (28B) du deuxième étage (B) par l'intermédiaire du circuit de couplage (34), pour réaliser un filtre à quatre pôles à entrées et sorties différentielles et à couplage différentiel ; les entrées et sorties différentielles pouvant être inversées du fait de la symétrie du filtre.

6. Filtre selon la revendication 4, caractérisé en ce que la première plage de connexion (23A) du premier étage (A) est reliée à la sixième plage de connexion (32A) du premier étage (A), la première plage de connexion (23B) du deuxième étage (B) est reliée à la sixième plage de connexion (32B) du deuxième étage (B), en ce que la deuxième plage de connexion (24A, 24B) et la cinquième plage de connexion (31A, 31B) du premier étage (A) et du deuxième étage (B) sont reliées à un même potentiel de référence, en ce que la troisième plage de connexion (27A) du premier étage (A) et la quatrième plage de connexion (28A) du premier étage (A) sont reliées respectivement à une première entrée différentielle (IN+) et une deuxième entrée différentielle (IN-), en ce que la troisième plage de connexion (27B) du deuxième étage (B) et la quatrième plage de connexion (28B) du deuxième étage (B) sont reliées respectivement à une première sortie différentielle (OUT+) et à une deuxième sortie différentielle (OUT-), et en ce que le premier étage (A) est couplé au deuxième étage (B) par l'intermédiaire d'un circuit de couplage (34) couplé entre la sixième plage de connexion (32A) du premier étage (A) et la première plage de connexion (23B) du deuxième étage (B), pour réaliser un filtre à quatre pôles à entrées et sorties différentielles et à couplage non différentiel ; les entrées et sorties différentielles pouvant être inversées du fait de la symétrie du filtre.

7. Filtre selon la revendication 6, caractérisé en ce qu'un filtre symétrique à deux pôles à entrées et sorties non différentielles (C) comportant une première plage de connexion extérieure (1) et une deuxième plage de connexion extérieure (5), est disposé à la place du deuxième étage (B), la première plage de connexion extérieur (1) du filtre à deux pôles (C) étant reliée au circuit de couplage (34) et la deuxième plage de connexion extérieur (5) étant reliée à la sortie non différentielle (OUT), pour réaliser un filtre à quatre pôles à entrées différentielles et sortie non différentielle et à couplage non différentiel.

8. Filtre selon la revendication 6, caractérisé en ce qu'un filtre symétrique à deux pôles à entrées et sorties non différentielles, comportant une première plage de connexion extérieure (1) et une deuxième plage de connexion extérieure (5), est couplé entre le premier étage (A) et le deuxième étage (B) par l'intermédiaire d'un premier circuit de couplage (34A) et d'un deuxième circuit de couplage (34B) respectivement couplés entre la sixième plage de connexion (32A) du premier étage (A) et la première plage de connexion extérieure (1) du filtre à deux pôles (C), et entre la deuxième plage de connexion extérieure (5) du filtre à deux pôles (C) et la première plage de connexion (23B) du deuxième étage (B) pour réaliser un filtre à six pôles à entrées et sorties différentielles et à couplage non différentiel.

9. Filtre selon la revendication 4, caractérisé en ce que la première plage de connexion (23A) du premier étage (A) est reliée à la sixième plage de connexion (32A) du premier étage (A) et à une entrée non différentielle (IN), la première plage de connexion (23B) du deuxième étage (B) est reliée à la sixième plage de connexion (32B) du deuxième étage (B) et à une sortie non différentielle (OUT), en ce que la deuxième plage de connexion (24A, 24B) et la cinquième plage de connexion (31A, 31B) de chaque étage (A et B) sont reliées à un même potentiel de référence, en ce que la troisième plage de connexion (27A) du premier étage (A) et la quatrième plage de connexion (28A) du premier étage (A) sont couplées respectivement à la troisième plage de connexion (27B) et à la quatrième plage de connexion (28B) du deuxième étage (B) par l'intermédiaire d'un circuit de couplage (34) pour réaliser un filtre à quatre pôles à entrée et sortie non différentielle et à couplage différentiel.

10. Filtre selon l'une quelconque des revendications 1 à 9, caractérisé en ce que les trois voies acoustiques ont une largeur quasi identique.

## Patentansprüche

1. Filter für akustische Oberflächenwellen mit Resonatoren und transversaler Kopplung sowie mit drei akustischen Kanälen, die durch gegenseitige Annäherung gekoppelt sind, dadurch gekennzeichnet,

   - daß der erste akustische Kanal (20), der einen ersten Transduktor mit einer ersten und einer zweiten Anschlußzone (23, 24) enthält und zwischen einem ersten Reflektor (25) und einem zweiten Reflektor (26) liegt, einen ersten Resonator bildet,
   - daß der zweite akustische Kanal (21), der einen zweiten Transduktor mit einer dritten und einer vierten Anschlußzone (27, 28) enthält und zwischen einem dritten Reflektor (29) und einem vierten Reflektor (30) liegt, einen zweiten Resonator bildet,
   - daß der dritte akustische Kanal (22), der einen dritten Transduktor mit einer fünften und einer sechsten Anschlußzone (31, 32) enthält und zwischen einem fünften Reflektor (33) und einem sechsten Reflektor (34) liegt, einen dritten Resonator bildet,
   - und daß jede Anschlußzone der Transduktoren an ein bestimmtes Potential angeschlossen und der zweite Resonator im Differentialmodus angeschlossen ist.

2. Filter nach Anspruch 1, dadurch gekennzeichnet, daß die zweite Anschlußzone (24) und die fünfte Anschlußzone (31) an ein gemeinsames Bezugspotential angeschlossen sind, daß die dritte Anschlußzone (27) mit einem ersten Differentialeingang (IN+) und die vierte Anschlußzone (28) mit einem zweiten Differentialeingang (IN-) verbunden sind, und daß die erste Anschlußzone (23) und die sechste Anschlußzone (32) mit dem Ausgang (OUT) verbunden sind.

3. Filter nach Anspruch 1, dadurch gekennzeichnet, daß die erste Anschlußzone (23) und die fünfte Anschlußzone (31) mit einem ersten Differentialeingang (IN+) verbunden sind, während die zweite Anschlußzone (24) und die sechste Anschlußzone (32) mit einem zweiten Differentialeingang (IN-) verbunden sind, und daß die dritte Anschlußzone (27) mit einem ersten Differentialausgang (OUT+) verbunden ist, während die vierte Anschlußzone (28) mit einem zweiten Differentialausgang (OUT-) verbunden ist, um ein zweipoliges Filter Differentialein- und -ausgängen zu bilden, wobei die Differentialeingänge und Differentialausgänge aufgrund der Symmetrie des Filters vertauscht werden können.

4. Filter mit N Polen, wobei N größer als zwei ist, dadurch gekennzeichnet, daß es mindestens eine erste Stufe (A) und eine zweite Stufe (B) besitzt, die je von einer Filterstruktur gemäß Figur 1 gebildet werden und miteinander über eine Kopplungsschaltung (34; 34A, 34B) gekoppelt sind.

5. Filter nach Anspruch 4, dadurch gekennzeichnet, daß die erste Anschlußzone (23A) und die fünfte Anschlußzone (31A) der ersten Stufe (A) mit einem ersten Differentialeingang (IN+) verbunden sind, daß die zweite Anschlußzone (24A) und die sechste Anschlußzone (32A) der ersten Stufe (A) mit einem zweiten Differentialeingang (IN-) verbunden sind, daß die erste Anschlußzone (23B) und die fünfte Anschlußzone (31B) der zweiten Stufe (B) mit einem ersten Differentialausgang (OUT+) verbunden sind, daß die zweite Anschlußzone (24B) und die sechste Anschlußzone (32B) der zweiten Stufe (B) mit einem zweiten Differentialausgang (OUT-) verbunden sind, und daß die dritte Anschlußzone (27A) und die vierte Anschlußzone (28A) der ersten Stufe (A) an die dritte Anschlußzone (27B) beziehungsweise an die vierte Anschlußzone (28B) der zweiten Stufe (B) über die Kopplungsschaltung (34) angeschlossen sind, um ein vierpoliges Filter mit Differentialein- und -ausgängen und mit Differentialkopplung zu bilden, wobei die Differentialein- und -ausgänge aufgrund der Symmetrie des Filters vertauscht werden können.

6. Filter nach Anspruch 4, dadurch gekennzeichnet, daß die erste Anschlußzone (23A) der ersten Stufe (A) mit der sechsten Anschlußzone (32A) der ersten Stufe (A) verbunden ist, daß die erste Anschlußzone (23B) der zweiten Stufe (B) mit der sechsten Anschlußzone (32B) der zweiten Stufe (B) verbunden ist, daß die zweite Anschlußzone (24A, 24B) und die fünfte Anschlußzone (25A, 25B) der ersten und der zweiten Stufe (A, B) an ein gemeinsames Bezugspotential angeschlossen sind, daß die dritte Anschlußzone (27A) beziehungsweise die vierte Anschlußzone (28A) der ersten Stufe (A) mit einem ersten Differentialeingang (IN+) beziehungsweise einem zweiten Differentialeingang (IN-) verbunden sind, daß die dritte Anschlußzone (27B) der zweiten Stufe (B) und die vierte Anschlußzone (28B) der zweiten Stufe (B) an einen ersten Differentialausgang (OUT+) beziehungsweise einen zweiten Differentialausgang (OUT-) angeschlossen sind, daß die erste Stufe (A) an die zweite Stufe (B) über eine Kopplungsschaltung (34) gekoppelt ist, die zwischen der sechsten Anschlußzone (32A) der ersten Stufe (A) und der ersten Anschlußzone (23B) der zweiten Stufe (B) liegt, um ein vierpoliges Filter mit Differentialein- und -ausgängen sowie nicht-differentialer Kopplung zu bilden, wobei die Differentialein- und -ausgänge aufgrund der Symmetrie des Filters vertauscht werden können.

7. Filter nach Anspruch 6, dadurch gekennzeichnet, daß ein symmetrisches zweipoliges Filter (C) mit nicht-differentialen Ein- und Ausgängen und einer ersten äußeren Anschlußzone (1) und einer zweiten äußeren Anschlußzone (5) anstelle der zweiten Stufe angeordnet ist, wobei die erste äußere Anschlußzone (1) des zweipoligen Filters (C) an die Kopplungsschaltung (34) und die zweite äußere Anschlußzone (5) an den nicht-differentialen Ausgang (OUT) angeschlossen ist, um ein vierpoliges Filter mit Differentialeingängen sowie einem nicht-differentialen Ausgang und einer nicht-differentialen Kopplung zu bilden.

8. Filter nach Anspruch 6, dadurch gekennzeichnet, daß ein symmetrisches zweipoliges Filter mit nicht-differentialen Ein- und Ausgängen und einer ersten äußeren Anschlußzone (1) und einer zweiten äußeren Anschlußzone (5) zwischen die erste Stufe (A) und die zweite Stufe (B) über eine erste Kopplungsschaltung (34A) und eine zweite Kopplungsschaltung (34B) eingefügt ist, die zwischen die sechste Anschlußzone (34A) der ersten Stufe (A) und die erste äußere Anschlußzone (1) des zweipoligen Filters (C) beziehungsweise zwischen die zweite äußere Anschlußzone (5) des zweipoligen Filters (C) und die erste Anschlußzone (23B) der zweiten Stufe (B) eingefügt sind, um ein sechspoliges Filter mit Differentialein- und -ausgängen sowie mit einer nicht-differentialen Kopplung zu bilden.

9. Filter nach Anspruch 4, dadurch gekennzeichnet, daß die erste Anschlußzone (23A) der ersten Stufe (A) mit der sechsten Anschlußzone (32A) der ersten Stufe (A) und einem nicht-differentialen Eingang (IN) verbunden ist, daß die erste Anschlußzone (23B) der zweiten Stufe (B) mit der sechsten Anschlußzone (23B) der zweiten Stufe (B) und einem nicht-differentialen Ausgang (OUT) verbunden ist, daß die zweiten Anschlußzone (24A, 24B) und die fünften Anschlußzone (31A, 31B) beider Stufen (A, B) an ein gemeinsames Bezugspotential angeschlossen sind, daß die dritte Anschlußzone (24A) der ersten Stufe (A) und die vierte Anschlußzone (28A) der ersten Stufe (A) mit der dritten Anschlußzone (27B) beziehungsweise der vierten Anschlußzone 28B) der zweiten Stufe (B) über eine Kopplungsschaltung (34) gekoppelt sind, um ein vierpoliges Filter mit nicht-differentialen Ein- und Ausgängen sowie mit Differentialkopplung zu bilden.

10. Filter nach einem beliebigen der Ansprüche 1 bis 9, dadurch gekennzeichnet, daß die drei akustischen Kanäle praktisch die gleiche Breite besitzen.

**Claims**

1. Surface acoustic wave filter having resonators with transverse coupling, comprising three acoustic pathways coupled by proximity, characterized in that:

   - the first acoustic pathway (20) made up of a first transducer, comprising a first and a second bonding pad (23 and 24), and arranged between a first reflector (25) and a second reflector (26), forms a first resonator,
   - the second acoustic pathway (21) made up of a second transducer, comprising a third bonding pad and a fourth bonding pad (27 and 28), and arranged between a third reflector (29) and a fourth reflector (30), forms a second resonator, and
   - the third acoustic pathway (22) made up of a third transducer, comprising a fifth and a sixth bonding pad (31 and 32), and arranged between a fifth reflector (33) and a sixth reflector (34), forms a third resonator,

   and in that each bonding pad of the transducers is linked to a specified potential and in that the second resonator is connected in differential mode.

2. Filter according to Claim 1, characterized in that the second bonding pad (24) and the fifth bonding pad (31) are linked to the same reference potential, in that the third bonding pad (27) is linked to a first differential input (IN+) and the fourth bonding pad (28) is linked to a second differential input (IN-), and in that the first bonding pad (23) and the sixth bonding pad (32) are linked to the output (OUT).

**3.** Filter according to Claim 1, characterized in that the first bonding pad (23) and the fifth bonding pad (31) are linked to a first differential input (IN+), while the second bonding pad (24) and the sixth bonding pad (32) are linked to a second differential input (IN-), and in that the third bonding pad (27) is linked to a first differential output (OUT+), while the fourth bonding pad (28) is linked to a second differential output (OUT-) so as to produce a two-pole filter with differential inputs and outputs; the differential inputs and outputs being invertible on account of the symmetry of the filter.

**4.** Filter with N poles, with N greater than two, characterized in that it comprises at least one first stage (A) and one second stage (B), each consisting of a filter structure according to Claim 1, and in that they are coupled together by way of a coupling circuit (34; 34A; 34B).

**5.** Filter according to Claim 4, characterized in that the first bonding pad (23A) and the fifth bonding pad (31A) of the first stage (A) are linked to a first differential input (IN+), in that the second bonding pad (24A) and the sixth bonding pad (32A) of the first stage (A) are linked to a second differential input (IN-), in that the first bonding pad (23B) and the fifth bonding pad (31B) of the second stage (B) are linked to a first differential output (OUT+), in that the second bonding pad (24B) and the sixth bonding pad (32B) of the second stage (B) are linked to a second differential output (OUT-) and, in that the third bonding pad (27A) and the fourth bonding pad (28A) of the first stage (A) are linked respectively to the third bonding pad (27B) and to the fourth bonding pad (28B) of the second stage (B) by way of the coupling circuit (34), so as to produce a four-pole filter with differential inputs and outputs and with differential coupling; the differential inputs and outputs being invertible on account of the symmetry of the filter.

**6.** Filter according to Claim 4, characterized in that the first bonding pad (23A) of the first stage (A) is linked to the sixth bonding pad (32A) of the first stage (A), the first bonding pad (23B) of the second stage (B) is linked to the sixth bonding pad (32B) of the second stage (B), in that the second bonding pad (24A, 24B) and the fifth bonding pad (31A, 31B) of the first stage (A) and of the second stage (B) are linked to one and the same reference potential, in that the third bonding pad (27A) of the first stage (A) and the fourth bonding pad (28A) of the first stage (A) are linked respectively to a first differential input (IN+) and a second differential input (IN-), in that the third bonding pad (27B) of the second stage (B) and the fourth bonding pad (28B) of the second stage (B) are linked respectively to a first differential output (OUT+) and to a second differential output (OUT-), and in that the first stage (A) is coupled to the second stage (B) by way of a coupling circuit (34) coupled between the sixth bonding pad (32A) of the first stage (A) and the first bonding pad (23B) of the second stage (B), so as to produce a four-pole filter with differential inputs and outputs and with non-differential coupling; the differential inputs and outputs being invertible on account of the symmetry of the filter.

**7.** Filter according to Claim 6, characterized in that a symmetric filter with two poles with non-differential inputs and outputs (C) comprising a first outer bonding pad (1) and a second outer bonding pad (5) is arranged in place of the second stage (B), the first outer bonding pad (1) of the filter with two poles (C) being linked to the coupling circuit (34) and the second outer bonding pad (5) being linked to the non-differential output (OUT), so as to produce a four-pole filter with differential inputs and non-differential output and with non-differential coupling.

**8.** Filter according to Claim 6, characterized in that a symmetric filter with two poles with nondifferential inputs and outputs, and comprising a first outer bonding pad (1) and a second outer bonding pad (5), is coupled between the first stage (A) and the second stage (B) by way of a first coupling circuit (34A) and a second coupling circuit (34B) respectively coupled between the sixth bonding pad (32A) of the first stage (A) and the first outer bonding pad (1) of the two-pole filter (C), and between the second outer bonding pad (5) of the two-pole filter (C) and the first bonding pad (23B) of the second stage (B) so as to produce a six-pole filter with differential inputs and outputs and with non-differential coupling.

**9.** Filter according to Claim 4, characterized in that the first bonding pad (23A) of the first stage (A) is linked to the sixth bonding pad (32A) of the first stage (A) and to a non-differential input (IN), the first bonding pad (23B) of the second stage (B) is linked to the sixth bonding pad (32B) of the second stage (B) and to a non differential output (OUT), in that the second bonding pad (24A, 24B) and the fifth bonding pad (31A, 31B) of each stage (A and B) are linked to the same reference potential, and in that the third bonding pad (27A) of the first stage (A) and the fourth bonding pad (28A) of the first stage (A) are coupled respectively to the third bonding pad (27B) and to the fourth bonding pad (28B) of the second stage (B) by way of a coupling circuit (34) so as to produce a four-pole filter with non-differential input and output and with differential coupling.

**10.** Filter according to any one of Claims 1 to 9, characterized in that the three acoustic pathways have a near-identical width.

OUT

5

6

7

2

3

1

4

8

9

IN

FIG.1    ART ANTÉRIEUR

OUT

5

6

7

2

3

1

4

IN

FIG.2    ART ANTÉRIEUR

FIG.3 ART ANTÉRIEUR

FIG.4

FIG.5

FIG.6

FIG.7

FIG. 8

FIG.9

FIG.10

FIG.11